Europäisches Patentamt

European Patent Office

Office européen des brevets

(19)

(11) Veröffentlichungsnummer: **0 158 876**
**A2**

(12) # EUROPÄISCHE PATENTANMELDUNG

(21) Anmeldenummer: 85103594.9

(51) Int. Cl.⁴: **H 05 K 3/46**

(22) Anmeldetag: 26.03.85

(30) Priorität: 03.04.84 DE 3412290

(43) Veröffentlichungstag der Anmeldung:
23.10.85 Patentblatt 85/43

(84) Benannte Vertragsstaaten:
AT BE CH FR GB IT LI LU NL SE

(71) Anmelder: SYSTEM KONTAKT Gesellschaft für
elektronische Bauelemente mbH
Siemensstrasse 5
D-7107 Bad Friedrichshall(DE)

(72) Erfinder: Eberbach, Rolf
Bahnhofstrasse 48
D-7014 Kornwestheim(DE)

(72) Erfinder: Leitl, Franz
Lessingstrasse 9
D-6921 Siegelsbach(DE)

(74) Vertreter: Vogel, Georg
Hermann-Essig-Strasse 35
D-7141 Schwieberdingen(DE)

(54) **Mehrlagige Leiterplatte in Multilayer- oder Stapeltechnik.**

(57) Die Erfindung betrifft eine mehrlagige Leiterplatte in Multilayer- oder Stapeltechnik mit mehreren übereinander liegenden Lagen, bei der zumindest ein Teil der Innenlagen mit als Leiterbahnen ausgebildeten und im Abstand zueinander angeordneten Signalleitungen versehen ist. Damit die Signalleitungen sowohl auf den beiden Außenlagen, als auch Innenlagen mit gleichen übertragungstechnischen Eigenschaften aufgebracht werden können, sieht die Erfindung vor, daß die den Innenlagen mit Leiterbahnen benachbarten Innenlagen im Bereich dieser Leiterbahnen so ausgespart sind, daß zumindest die zugekehrten Oberseiten dieser Leiterbahnen freiliegen.

Fig 2

EP 0 158 876 A2

0158876

## Mehrlagige Leiterplatte in Multilayer- oder Stapeltechnik

Die Erfindung betrifft eine mehrlagige Leiterplatte in Multilayer- oder Stapeltechnik mit mehreren übereinander liegenden Lagen, bei der zumindest ein Teil der Innenlagen mit als Leiterbahnen ausgebildeten und im Abstand zueinander angeordneten Signalleitungen versehen ist.

Die Multilayer- und Stapeltechnik hat sich bei mehrlagigen Leiterplatten mehr und mehr eingeführt, da immer mehr Signalleitungen auf einem vorgegebenen Maß unterzubringen sind. Dabei werden die Signalleitungen einfach als Leiterbahnen auf verschiedene Lagen der mehrlagigen Leiterplatte verteilt. Dabei spielt es keine Rolle, ob die Leiterplatte in Multilayer- oder in Stapeltechnik hergestellt wird.

In den letzten Jahren haben sich die Anforderungen an die Signalübertragungswege in Mikro- und Minicomputersystemen drastisch verändert. Da diese Signalübertragungswege auch über die Leiterplatten, die z.B. als Rückplatte für Baugruppenträger zur Aufnahme von Einschub-Leiterplatten mit Steckverbinder verwendet werden, geführt werden, trifft dies auch für diese Leiterplatten zu. Mit zunehmender Verarbeitungsgeschwindigkeit ergibt sich die Notwendigkeit, auch übertragungstechnische Gesichtspunkte wie Wellenwiderstand, Reflexionen, Verluste und Übersprechen der Signalübertragungswege bei der Auslegung von Leiterplatten der eingangs erwähnten Art zu berücksichtigen.

Dabei ergeben sich gerade bei einem kleinen Abstand der als Leiterbahnen ausgebildeten Signalleitungen erhebliche Schwierigkeiten, wenn diese sowohl auf die Außenlagen, als auch auf die Innenlagen der mehrlagigen Leiterplatte verteilt werden. Da sich die übertragungstechnischen Eigenschaften der auf die Innenlagen verteilten Signalleitungen wesentlich von den übertragungstechnischen Eigenschaften der auf den Außenlagen angeordneten Signalleitungen unterscheiden, lassen sich die bekannten mehrlagigen Leiterplatten in dieser Art nicht für den Einsatz in Systemen mit großen Verarbeitungsgeschwindigkeiten verwenden.

Wie die europ. Patentanmeldung Nr. 0 027 047 zeigt, hat man diese Schwierigkeiten schon dadurch versucht auszuschalten, daß die Signalleitungen nur auf die Außenlagen der Leiterplatte verteilt werden. Dies hat jedoch zur Folge, daß auf einem gegebenen Maß und einer gegebenen Anzahl von Signalleitungen der Abstand zwischen den Signalleitungen sehr klein wird, insbesondere dann, wenn zwischen den Signalleitungen auch noch Abschirmleitungen angeordnet werden müssen. Mit kleiner werdendem Abstand der Signalleitungen steigt das Übersprechen in den über die Leiterplatte geführten Signalübertragungswegen an, was besonders bei großen Verarbeitungsgeschwindigkeiten Schwierigkeiten bereiten kann.

Es ist Aufgabe der Erfindung, eine mehrlagige Leiterplatte der eingangs erwähnten Art zu schaffen, bei der sowohl auf den Außenlagen, als auch den Innenlagen Signalübertragungswege angeordnet werden können, ohne unterschiedliche übertragungstechnische Eigenschaften für die Signalübertragungswege zu bekommen.

Diese Aufgabe wird nach der Erfindung dadurch gelöst, daß die den Innenlagen mit Leiterbahnen benachbarten Innenlagen im Bereich dieser Leiterbahnen so ausgespart sind, daß zumindest die zugekehrten Oberseiten dieser Leiterbahnen freiliegen.

Mit den Aussparungen in den benachbarten Innenlagen werden die übertragungstechnischen Eigenschaften dieser Signalübertragungswege an die übertragungstechnischen Eigenschaften der Signalübertragungswege auf den Außenlagen der Leiterplatte angepaßt, da dann alle Leiterbahnen von Luft umgeben sind und gleiche übertragungstechnische Bedingungen aufweisen. Dabei kann mit den Abmessungen der Aussparungen der Wellenwiderstand der Signalübertragungswege über die Leiterplatte festgelegt werden und zwar auf den Wert, den die Signalübertragungswege auf den Außenlagen der Leiterplatte haben. Da die Signalleitungen nunmehr auf mehr als zwei Lagen verteilt werden können, ergibt sich der zusätzliche Vorteil, daß bei einem vorgegebenen Maß und einer vorgegebenen Anzahl von Signalleitungen der Abstand zwischen den Signalleitungen größer gemacht werden kann, was sich in einer Reduzierung des Verlustes der über die Leiterplatte geführten Signalübertragungswege auswirkt. Dies gilt sowohl für Leiterplatten mit oder ohne Abschirmleitungen zwischen den Signalleitungen.

Die Aussparungen legen nach einer bevorzugten Ausgestaltung die Leiterbahnen der Innenlagen an drei Seiten frei.

Wird die mehrlagige Leiterplatte in Stapeltechnik mit übereinander angeordneten Platten hergestellt, dann ist nach einer einfachen Ausgestaltung zur Einbringung der Ausparungen in die Innenlagen vorgesehen, daß die Aussparungen als Schlitze oder Nuten in die die benachbarten Innenlagen
bildenden Platten eingebracht sind.

Werden die mehrlagigen Leiterplatten als Rückplatten für
Baugruppenträger verwendet, die mit Steckverbinder versehene
Einschub-Leiterplatten aufnehmen, dann ist eine Ausgestaltung von Vorteil, die dadurch gekennzeichnet ist, daß die
als Schlitze ausgebildeten Aussparungen sich über Teilabschnitte der unterteilten Leiterbahnen erstrecken und daß
die Teilabschnitte der Leiterbahnen in Bohrungen zum Anschluß von Steckverbindern enden.

Eine Ausgestaltung für eine Rückplatte dieser Art ist weiterhin dadurch gekennzeichnet, daß die beiden Außenlagen mit
als Leiterbahnen ausgebildeten Signalleitungen versehen
sind, daß die den Außenlagen benachbarten Innenlagen jeweils
durch eine plattenförmige Massebahn gebildet sind, daß diese
Massebahnen jeweils mittels einer Isolierlage abgedeckt
sind, daß zwischen diesen beiden Isolierlagen mindestens
zwei durch eine mittlere Isolierlage voneinander getrennte
Doppellagen angeordnet sind, daß die eine Doppellage mittels
zweier gegeneinander isolierter plattenförmiger Massebahnen
mit Aussparungen gebildet ist, daß die der mittleren Isolierlage zugekehrte Lage der anderen Doppellage als Leiterbahnen ausgebildete Signalleitungen trägt, wobei die Leiterbahnen in den Aussparungen der einen Doppellage freiliegen
und daß die der mittleren Isolierlage abgekehrte Lage der
anderen Doppellage als plattenförmige Massebahn ausgebildet
ist. Dabei können über die Massebahnen zwei getrennte Stromversorgungswege für die Einschub-Leiterplatten gebildet
werden.

Um die Aussparung um die Leiterbahnen der Innenlagen möglichst groß halten zu können, sieht eine weitere Ausgestaltung vor, daß sich die Aussparungen durch die beiden als
plattenförmige Massebahnen ausgebildeten Lagen der einen
Doppellage erstrecken.

Eine Abschirmung der Signalübertragungswege wird dabei
dadurch erreicht, daß zwischen den als Leiterbahnen ausgebildeten Signalleitungen als Leiterbahnen ausgebildete
Abschirmleitungen angeordnet sind, die mit einer als plattenförmige Massebahn ausgebildeten benachbarten Lage kontaktiert sind.

Die Abschirmung der Signalübertragungswege kann nach einer
Weiterbildung dadurch verbessert werden, daß die als Leiterbahnen ausgebildeten Signalleitungen alle auf Innenlagen
angeordnet sind, daß die beiden Außenlagen mittels plattenförmiger Massebahnen gebildet sind und daß die die Leiterbahnen freilegenden Aussparungen an ihren Wänden einen mit
einer als plattenförmige Massebahn ausgebildeten benachbarten Lage verbundenen Abschirmbelag tragen. Die Signalleitungen bilden bei dieser Ausgestaltung mit den Abschirmbelägen
in den Aussparungen und mit den angrenzenden und damit
verbundenen Massebahnen eine Art von koaxialen Signalübertragungswegen.

Damit die Signalübertragungswege durch äußere Störfelder
nicht beeinflußt werden können, sieht eine weitere Ausgestaltung vor, daß die den Außenlagen benachbarten Innenlagen
die Leiterbahnen tragen, daß die anschließenden Innenlagen
mit den Aussparungen versehen sind und daß die Abschirmbeläge der von diesen Innenlagen ausgehenden Aussparungen mit aufeinander liegenden und in Form von plattenförmigen Massebahnen ausgebildeten Innenlagen verbunden sind.

Die Erfindung wird anhand von in den Zeichnungen dargestellten Ausführungsbeispielen näher erläutert. Es zeigt:

Fig. 1 schematisch einen Teilquerschnitt durch eine
achtlagige Leiterplatte mit auf die Außenlagen und eine
Innenlage verteilten Signalleitungen.

Fig. 2 in Explosionsdarstellung einen Teil der vier
Platten zum Aufbau einer Leiterplatte nach Fig. 1 in
Stapeltechnik und

Fig. 3 einen Teilquerschnitt einer Leiterplatte, bei
der alle Signalleitungen voll geschirmt auf Innenlagen
angeordnet sind.

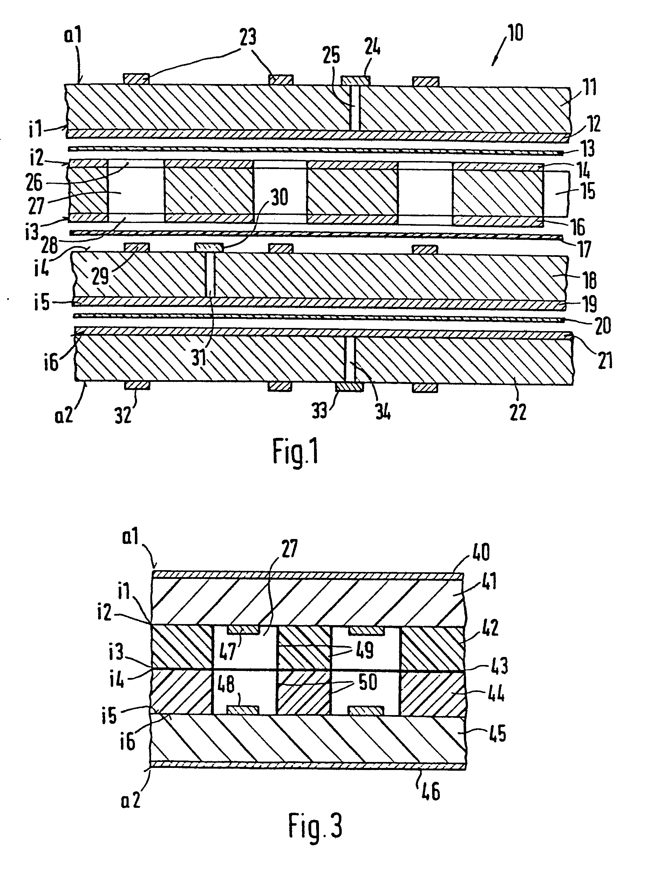

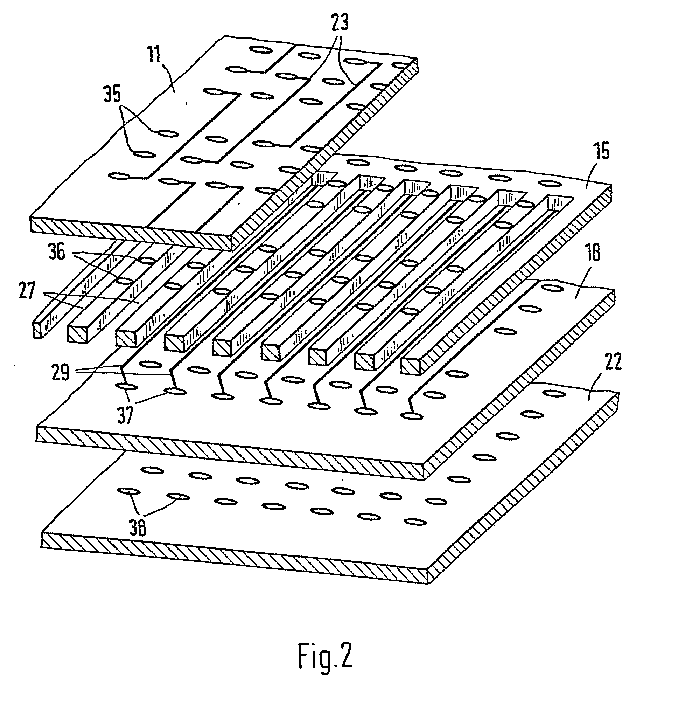

Der Teilquerschnitt nach Fig. 1 und die Teilansicht nach
Fig. 2 zeigen ein Ausführungsbeispiel einer Leiterplatte 10
mit acht Lagen und zwar den beiden Außenlagen a1 und a2,
sowie den sechs Innenlagen i1 bis i6. Diese mehrlagige
Leiterplatte 10 ist in Stapeltechnik aufgebaut, wie die
Platten 11,15,18 und 22 zeigen. Auf den beiden Außenlagen a1
und a2 sind die als Leiterbahnen 23 und 32 ausgebildeten
Signalleitungen aufgebracht, die jeweils in gleichmäßigen
Abständen zueinander verlaufen. Die Innenlage i1 an der
Platte 11 wird durch die plattenförmige Massebahn 12 gebildet und auch die Innenlage i6 an der Platte 22 wird durch
eine gleiche Massebahn 21 gebildet. Sind zwischen den Signalleitungen als Leiterbahnen 24 und 33 ausgebildete Abschirmleitungen auf den Außenlagen a1 und a2 aufgebracht,
dann werden diese mit den Massebahnen 12 und 21 kontaktiert,
wie die Bohrungen 25 und 34 andeuten.

Die Massebahnen 12 und 21 werden durch die Isolierlagen 13 und 20 abgedeckt. Zwischen diesen Isolierlagen 13 und 20 sind die beiden Platten 15 und 18 angeordnet, die die Innenlagen i2 und i3 bzw. i4 und i5 bilden. Die beiden Platten 15 und 18 und damit die Innenlagen i3 und i4 sind durch die mittlere Isolierlage 17 elektrisch voneinander getrennt. Die Innenlagen i2 und i3 werden durch die Massebahnen 14 und 16 gebildet, die aber mit durchgehenden Aussparungen 27 versehen sind, die mit den als Leiterbahnen 29 ausgebildeten Signalleitungen auf der Innenlage i4 der Platte 18 fluchten und diese zumindest an der der Innenlage i3 zugekehrten Oberseite freilegen.

Die Innenlage i5 der Platte 18 trägt die Massebahn 19, mit der als Leiterbahnen 30 ausgebildete Abschirmleitungen kontaktiert werden können, wie die Bohrung 31 zeigt. Auf diese Weise erhält die Leiterplatte 10 zwei Stromversorgungswege, die über die Massebahnen 12 und 14 bzw. 19 und 21 verlaufen und die z.B. für zwei unterschiedliche Versorgungsspannungen verwendet werden können.

Wie Fig. 2 erkennen läßt, können die Aussparungen 27 in der Platte 15 als Schlitze ausgebildet sein. Wird die Leiterplatte 10 als Rückplatte für einen Baugruppenträger verwendet, dann sind die Leiterbahnen 23, 29 und 32 in Abschnitte unterteilt und enden in den Bohrungen 35, 37 und 38, die Stifte von Steckverbindern aufnehmen können. Die Aussparungen 27 sind dann ebenfalls unterteilt und nehmen die Abschnitte der Leiterbahnen 29 auf. Dabei legen die Aussparungen 27 die Leiterbahnen 29 vorzugsweise dreiseitig fest. Die Abmessungen der Aussparungen können so gewählt werden, daß die über die Leiterbahnen 29 geführten Signalübertragungswege die gleichen übertragungstechnischen Eigenschaften aufweisen, wie die über die Leiterbahnen 23 und 32 geführten Signalübertragungswege. Durch die Ausnutzung der beiden Außenlagen a1 und a2, sowie der Innenlage i4 für die Anordnung von Signalleitungen läßt sich bei einem vorgegebenen Maß der Leiterplattenbreite und bei einer vorgegebenen Anzahl von Signalleitungen der Abstand zwischen den benachbarten Leiterbahnen 23, 29 und 32 entsprechend vergrößern, was sich günstig auf das übertragungstechnische Verhalten der Signalübertragungswege auswirkt.

Es ist leicht einzusehen, daß sich durch weitere Paare aus einer Platte 15 und einer Platte 18 weitere Innenlagen zur Anordnung von Signalleitungen gewinnen lassen, die zwischen die Massebahn 12 und die Isolierlage 13 oder zwischen die Massebahn 21 und die Isolierlage 20 eingefügt werden können.

Es ist durchaus im Rahmen der Erfindung, die Leiterplatte 10 nach den Fig. 1 und 2 ohne die Massebahnen 12,14,16,19 und 20, sowie den als Leiterbahnen 24,30 und 34 ausgebildeten Abschirmleitungen aufzubauen, wenn es die Verarbeitungsgeschwindigkeit zuläßt.

Es ist unter Weglassung der Platte 15 auch möglich, die Aussparungen 27 in die die Innenlage i1 bildende Seite der Platte 11 einzubringen.

Die Aussparungen 27 können auch nur als Nuten in die Platte 15 eingebracht sein und zwar auf der die Innenlage i3 bildenden Seite der Platte 15. Die Innenlage mit Aussparungen kann jedoch auch nur durch entsprechend verteilte Abstandselemente gebildet werden.

Das Ausführungsbeispiel nach Fig. 3 zeigt eine Leiterplatte, bei der alle Signalleitungen auf Innenlagen angeordnet sind, um diese voll abzuschirmen. Die Außenlagen a1 und a2 der Platten 41 und 45 tragen die Massebahnen 40 und 46, die das Eindringen von externen Störsignalen verhindern. Auf den Innenlagen i1 und i6 der Platten 41 und 46 sind die als Leiterbahnen 47 und 48 ausgebildeten Signalleitungen aufgebracht. Die Platten 42 und 44 bilden die Innenlagen i2 und i3, sowie i4 und i5; sie können auch als Abstandshalter ausgebildet sein. Die Leiterbahnen 47 und 48 bzw. ihre unterteilten Abschnitte liegen in den Aussparungen 27 der Platten 42 und 44 frei und zwar an drei Seiten. Die Wände der Aussparungen 27 tragen Abschirmbeläge 49 und 50, die von den Innenlagen i2 und i5 ausgehen und mit Massebahnen 43 verbunden sind, die auf den Platten 42 und 44 als Innenlagen i3 und i4 aufgebracht sind. Die Leiterbahnen 47 und 48 sind dann praktisch allseitig abgeschirmt und die Signalübertragungswege sind nach Art einer Koaxialleitung ausgebildet. Da die Signalleitungen in den Aussparungen 27 freiliegen und von Luft umgeben sind, lassen sich sehr gute übertragungstechnische Werte für die Signalübertragungswege realisieren.

Die Anzahl der zu belegenden Innenlagen läßt sich durch weitere Platten 42 und 43 vergrößern. Dabei können auch die Platten 41 und 45 beidseitig Leiterbahnen tragen, wenn sich diese Plattenpaare anstelle der Massebahnen 40 oder 46 anschließen. Wichtig ist lediglich, daß die beiden Außenlagen jeweils durch eine Massebahn gebildet ist.

0158876

SYSTEM KONTAKT
Gesellschaft für elektronische
Bauelemente mbH
Siemensstraße 5

7107 Bad Friedrichshall


- 1 -


A n s p r ü c h e

1. Mehrlagige Leiterplatte in Multilayer- oder Stapeltechnik mit mehreren übereinander liegenden Lagen, bei der
   zumindest ein Teil der Innenlagen mit als Leiterbahnen
   ausgebildeten und im Abstand zueinander angeordneten
   Signalleitungen versehen ist,
   dadurch gekennzeichnet,
   daß die den Innenlagen (i4;i1,i6) mit Leiterbahnen
   (29;47,48) benachbarten Innenlagen (i3;i2,i4) im Bereich dieser Leiterbahnen (29;47,48) so ausgespart
   sind, daß zumindest die zugekehrten Oberseiten dieser
   Leiterbahnen (29;47,48) freiliegen.

2. Leiterplatte nach Anspruch 1,
   dadurch gekennzeichnet,
   daß die Aussparungen (27) die Leiterbahnen (29;47,48)
   der Innenlagen (i3;i2,i4) an drei Seiten freilegen.

3. Leiterplatte nach Anspruch 1 oder 2,
   dadurch gekennzeichnet,

daß mit den Abmessungen der Aussparungen (27) der Wellenwiderstand der Leiterbahnen (29;47,48) festlegbar ist.

4. Leiterplatte in Stapeltechnik mit übereinander angeordneten Platten nach einem der Ansprüche 1 bis 3,
dadurch gekennzeichnet,
daß die Aussparungen (27) als Schlitze oder Nuten in die die benachbarten Innenlagen (i3;i2,i4) bildenden Platten (15;42,44) eingebracht sind.

5. Leiterplatte nach Anspruch 4,
dadurch gekennzeichnet,
daß die als Schlitze ausgebildeten Aussparungen (27) sich über Teilabschnitte der unterteilten Leiterbahnen (29;47,48) erstrecken und
daß die Teilabschnitte der Leiterbahnen (29;47,48) in Bohrungen (37) zum Anschluß von Steckverbindern enden.

6. Leiterplatte nach einem der Ansprüche 1 bis 5,
dadurch gekennzeichnet,
daß beide Außenlagen (a1,a2) mit als Leiterbahnen (23,32) ausgebildeten Signalleitungen versehen sind.

7. Leiterplatte nach einem der Ansprüche 1 bis 6,
dadurch gekennzeichnet,
daß die beiden Außenlagen (a1,a2) mit als Leiterbahnen (23,32) ausgebildeten Signalleitungen versehen sind,
daß die den Außenlagen (a1,a2) benachbarten Innenlagen (i1,i6) jeweils durch eine plattenförmige Massebahn (12,21) gebildet sind,
daß diese Massebahnen (12,21) jeweils mittels einer Isolierlage (13,19) abgedeckt sind,

daß zwischen diesen beiden Isolierlagen (13,19) mindestens zwei durch eine mittlere Isolierlage (17) voneinander getrennte Doppellagen (i2,i3;i4,i5) angeordnet sind,

daß die eine Doppellage (i2,i3) mittels zweier gegeneinander isolierter plattenförmiger Massebahnen (14,16) mit Aussparungen (27) gebildet ist,

daß die der mittleren Isolierlage (17) zugekehrte Lage (i4) der anderen Doppellage (i4,i5) als Leiterbahnen (29) ausgebildete Signalleitungen trägt, wobei die Leiterbahnen (29) in den Aussparungen (27) der einen Doppellage (i2,i3) freiliegen und

daß die der mittleren Isolierlage (17) abgekehrte Lage (i5) der anderen Doppellage (i4,i5) als plattenförmige Massebahn (19) ausgebildet ist (Fig. 1).

8. Leiterplatte nach Anspruch 7,
dadurch gekennzeichnet,
daß sich die Aussparungen (27) durch die beiden als plattenförmige Massebahnen (14,16) ausgebildeten Lagen (i2,i3) der einen Doppellage (i2,i3) erstrecken.

9. Leiterplatte nach einem der Ansprüche 1 bis 8,
dadurch gekennzeichnet,
daß zwischen den als Leiterbahnen (23,29,32;47,48) ausgebildeten Signalleitungen als Leiterbahnen (24,30,34) ausgebildete Abschirmleitungen angeordnet sind, die mit einer als plattenförmige Massebahn (12,19,21) ausgebildeten benachbarten Lage (i1,i5,i6) kontaktiert sind.

10. Leiterplatte nach einem der Ansprüche 1 bis 6,
    dadurch gekennzeichnet,
    daß die als Leiterbahnen (47,48) ausgebildeten Signalleitungen alle auf Innenlagen (i1,i6) angeordnet sind,
    daß die beiden Außenlagen (a1,a2) mittels plattenförmiger Massebahnen (40,46) gebildet sind und
    daß die die Leiterbahnen (47,48) freilegenden Aussparungen (27) an ihren Wänden einen mit einer als plattenförmige Massebahn (43) ausgebildeten benachbarten
    Lage (i3,i4) verbundenen Abschirmbelag (49,50) tragen
    (Fig. 3).

11. Leiterplatte nach Anspruch 10,
    dadurch gekennzeichnet,
    daß die den Außenlagen (a1,a2) benachbarten Innenlagen
    (i1,i6) die Leiterbahnen (47,48) tragen,
    daß die anschließenden Innenlagen (i2,i5) mit den Aussparungen versehen sind, und
    daß die Abschirmbeläge (49,50) der von diesen Innenlagen (i2,i5) ausgehenden Aussparungen (27) mit aufeinander liegenden und in Form von plattenförmigen Massebahnen (43) ausgebildeten Innenlagen (i3,i4) verbunden
    sind.

12. Leiterplatte nach einem der Ansprüche 1 bis 11,
    dadurch gekennzeichnet,
    daß die Innenlagen mit Aussparungen (27) mittels entsprechend verteilter Abstandselemente zwischen den
    benachbarten Lagen gebildet sind.

Fig.1

Fig.3

Fig.2